# EUROPÄISCHE PATENTSCHRIFT

(11) **EP 3 489 082 B1**
(45) Veröffentlichungstag und Bekanntmachung des Hinweises auf die Patenterteilung: **06.10.2021**
(21) Anmeldenummer: 17204004.0
(22) Anmeldetag: 28.11.2017
(51) Int. Cl.: B60Q 1/00, F21S 45/10, H01R 13/24, H01R 13/26, F21S 41/19, F21S 41/141, H05K 1/11, H05K 1/14, H05K 3/36, H01R 12/73, H01R 12/71, F21V 23/00, F21V 23/06

(54) **LICHTMODUL UND FAHRZEUGSCHEINWERFER**
LIGHT MODULE AND VEHICLE HEADLAMP
MODULE LUMINEUX ET PHARE DE VÉHICULE

(43) Veröffentlichungstag der Anmeldung: 29.05.2019
(73) Patentinhaber: ZKW Group GmbH, 3250 Wieselburg (AT)
(72) Erfinder: Mitterlehner, Stefan, 3240 Mank (AT); Mitterlehner, Thomas, 3240 Mank (AT)
(74) Vertreter: Patentanwaltskanzlei Matschnig & Forsthuber OG

(56) Entgegenhaltungen:
- EP-A1- 2 781 826
- WO-A1-2006/066530
- DE-U1- 29 910 417
- US-A1- 2015 229 057
- US-A1- 2016 273 751
- US-B1- 6 231 219

## Beschreibung

Die Erfindung betrifft ein Lichtmodul, umfassend eine erste Leiterplatte und eine zweite Leiterplatte, wobei auf der zweiten Leiterplatte zumindest eine Lichtquelle angeordnet ist.

Ferner betrifft die Erfindung einen Fahrzeugscheinwerfer, insbesondere einen KFZ-Scheinwerfer.

Bei modernen Fahrzeugscheinwerfern, insbesondere KFZ-Scheinwerfern, bzw. Lichtmodulen, insbesondere solchen, die eine variable Lichtverteilung erzeugen können, werden vermehrt sehr lichtstarke Lichtquellen, meist Halbleiterdioden in der Form von Hochstrom-LEDs oder Laserdioden eingesetzt. Die Stromaufnahme von Hochstrom-LEDs kann dabei mehrere Ampere betragen. Um die elektrischen Verluste klein zu halten, sollen die stromführenden Verbindungsleitungen kurz und folglich die relevanten Schaltungsteile geometrisch möglichst nahe aneinander liegen. Jedoch steigt durch die geometrische Nähe die Anfälligkeit für unerwünschte Störungen hinsichtlich elektromagnetischer Überkopplung von ersten Schaltungsteilen, durch welche sehr hohe Ströme fließen, zu zweiten Schaltungsteilen, welche empfindliche Elektronikkomponenten enthalten. Diese Störungen sind unerwünscht und sollen vermieden oder reduziert werden.

Bislang erfolgt dies häufig durch aufwendige und teure Schirmungen, geschirmte und festverlötete Leitungen und geschirmte Steckverbindungen, welche zudem Nachteile durch einen hohen erforderlichen Bauraum und eine komplizierte und teure Montage aufweisen können.

Steckverbindungen haben überdies den Nachteil, dass bei der Montage beispielsweise durch Verbinden eines Steckers mit einer zugeordneten Buchse relativ große Kräfte auf die Leiterplatten einwirken können, wenn zwei Leiterplatten normal aufeinander angeordnet sind, was wiederum bei Fahrzeugscheinwerfern bzw. Lichtmodulen häufig erforderlich sein kann.

Ferner können beispielswiese durch thermische Einwirkung während des Betriebs in einem Fahrzeug unerwünschte mechanische Spannungen zwischen zwei Leiterplatten auftreten, welche über eine unelastische Verbindung, beispielsweise durch eine Steckverbindung, miteinander verbunden sind.

Die Verwendung freiliegender Leitungen zur Verbindung zweier Leiterplatten ist in einem Lichtmodul häufig ungünstig, da die Leitungen häufig zusätzlich fixiert werden müssen, beispielsweise durch Kabelbinder oder Kabelkanäle, um beispielsweise eine Verbreitung durch Vibrationen des Fahrzeugs verursachte unerwünschte mechanische Lasten auf die Leitungen und Leiterplatten zu reduzieren.

Die Druckschrift EP 2 781 826 A1 offenbart in einem bekannten Lichtmodul eine erste Leiterplatte mit einer Lichtquelle. Die erste Leiterplatte ragt durch ein Fenster in einer Schirmung und ist anhand elastischer Kontaktelemente mit einer zweiten Leiterplatte verbunden.

Es ist Aufgabe der Erfindung die Nachteile im Stand der Technik zu überwinden.

Die Aufgabe wird durch ein Lichtmodul gemäß Anspruch 1 gelöst.

Dadurch wird erreicht, dass die erste und zweite Leiterplatte auf eine einfache Weise zuverlässig miteinander verbunden werden. Außerdem können durch ein oder mehrere Federkontakt-Elemente mechanische Montagetoleranzen ausgeglichen werden. Ferner wirkt während der Montage nahezu keine Kraft auf die erstmontierte Leiterplatte ein, da die Montagekraft von dem Federkontakt-Element aufgenommen wird.

Die Verwendung von Federkontakt-Elementen ist aus deshalb sehr vorteilhaft, da das Federkontakt-Element durch automatisierte Standard-Bestückungsverfahren auf einer Leiterplatte montiert werden kann. Dadurch kann die Anzahl an Bearbeitungsschritten und daher die Montagekosten gesenkt werden.

Es ist besonders vorteilhaft, dass die zu den Federkontakt-Elementen korrespondierenden Kontaktflächen sehr einfach in Form von metallisierten Flächen auf der Leiterplatte selbst hergestellt werden können und keine gesonderten Bauteile erfordern, welche jeweils eine Gegenseite zu dem Federkontakt-Element bilden würden.

Die Kombination von Federkontakt-Elementen und korrespondierenden Kontaktflächen erlaubt die Führung hoher Ströme (15 Ampere und mehr) über die hergestellte elektrische Verbindung.

Derartige Verbindungen sind insbesondere zur Herstellung einer niederohmigen Verbindung, beispielsweise eine Masse-Verbindung oder eine EMV-Verbindung zum Schutz vor elektromagnetischen Störungen geeignet.

In einer ersten Ausführungsvariante weist die erste Leiterplatte zumindest eine Kontaktfläche auf, welche zur Auflage des zumindest einen Federkontakt-Elements vorgesehen ist. Auf der zweiten Leiterplatte ist das zumindest eine Federkontakt-Element angeordnet.

In einer zweiten Ausführungsvariante ist auf der ersten Leiterplatte das zumindest eine Federkontakt-Element angeordnet. Die zweite Leiterplatte weist zumindest eine Kontaktfläche auf, welche zur Auflage des zumindest einen Federkontakt-Elements vorgesehen ist.

Es ist günstig, wenn die zumindest eine Kontaktfläche auf einer außenliegenden Leiterebene oder einer Stirnseite der ersten oder zweiten Leiterplatte ausgebildet ist, insbesondere durch eine durch Strukturierung eines Leiterplattenmaterials hergestellte Metallfläche oder eine, beispielsweise durch Galvanisierung aufgebrachte Metallbeschichtung auf der ersten oder zweiten Leiterplatte.

In manchen Ausführungsvarianten kann es vorteilhaft sein, wenn auf der zumindest einen Kontaktfläche zusätzlich ein elastisches oder fluides Kontaktmittel aufgebracht ist, welches elektrisch leitfähig ist und eingerichtet ist, bei Kontaktieren des zumindest einen Federkontakt-Elements mit der zumindest einen Kontaktfläche den Querschnitt der gebildeten elektrischen Verbindung zu vergrößern, um höhere Ströme über die elektrischen Verbindung leiten zu können. Dazu kann beispielsweise das elastische Kontaktmittel eine gummiartige Auflagematte sein, oder das fluide Kontaktmittel beispielsweise ein Klebstoff oder auch ein Lot sein, falls es für die Anordnung nicht unbedingt erforderlich ist, dass die Verbindung wieder lösbar ist und das fluide Kontaktmittel daher ausgehärtet oder verlötet werden kann. Mit anderen Worten kann die Spitze des Stifts des zumindest einen Federkontakt-Elements und die zumindest eine Kontaktfläche zusätzlich durch ein Kontaktmittel, das zwischen Stift und Kontaktfläche gelegen ist oder den Stift und die Kontaktfläche gemeinsam umgibt, der Querschnitt der elektrisch leitenden Verbindung vergrößert werden, um den Fluss höherer Ströme über die geschaffene Verbindung zu erlauben.

Es ist vorteilhaft, wenn die erste Leiterplatte eine Treiberschaltung zur Ansteuerung der zumindest einen Lichtquelle umfasst. Dabei ist die Treiberschaltung mit der zumindest einen Kontaktfläche verbunden. Außerdem kann die erste Leiterplatte aus FR4-Material hergestellt sein.

Es ist günstig, wenn die zweite Leiterplatte aus IMS-Material hergestellt ist. Für Leiterplatten mit hohen Anforderungen an die Wärmeabführung, wie bei einem Lichtmodul, welches Hochleistungsleuchtdioden oder Laserdioden umfassen kann, werden Basismaterialien mit Metallkernen wie Aluminium oder Kupfer verwendet. Diese Trägermaterialien werden auch als Direct Bonded Copper oder als Insulated metal substrate (IMS) bezeichnet.

Für einen kompakten Aufbau des Scheinwerfers ist es vorteilhaft, wenn zumindest ein Kühlkörper umfasst ist, welcher mit der zweiten Leiterplatte verbunden ist. Zusätzlich kann auch die erste Leiterplatte mit dem zumindest einen Kühlkörper verbunden sein.

Gemäß der Erfindung umfasst ein Gehäuse für das Lichtmodul, welches insbesondere für einen KFZ-Scheinwerfer geeignet ist, wobei zwischen dem Bauraum für die erste Leiterplatte und dem Bauraum für die zweite Leiterplatte eine elektromagnetische Schirmung mit einem Fenster angeordnet ist, durch welches Fenster zumindest ein Teil des zumindest einen Federkontakt-Elements hindurch ragt. Das Fenster ist vorteilhaft dabei so ausgeführt, dass der Rand des Fensters möglichst nahe an die Federkontakt-Elemente heranreicht. Es ist vorteilhaft, wenn das Fenster in der Geometrie so bemessen ist, dass eine elektromagnetische Überkopplung von ersten elektrischen Signalen der Treiberschaltung, welche auf der ersten Leiterplatte geführt sind, zu zweiten elektrischen Signalen der Lichtquellen, welche auf der zweiten Leiterplatte geführt sind, und umgekehrt, reduziert wird.

Erfindungsgemäß ist die elektromagnetische Schirmung durch zumindest ein Teil des Gehäuses des Lichtmoduls gebildet.

Die erfindungsgemäße Aufgabe wird auch durch einen eingangs genannten Fahrzeugscheinwerfer gelöst, welcher zumindest ein erfindungsgemäßes Lichtmodul umfasst. Ein erfindungsgemäßes Lichtmodul weist durch die spezifische Anordnung der Leiterplatten Vorteile insbesondere für die Verwendung in einem Kraftfahrzeugscheinwerfer auf, da dadurch sehr vorteilhafte Freiheitsgrade bei der Konzeption und bei der Konstruktion erreicht werden können.

Für einen erfindungsgemäßen Kraftfahrzeugscheinwerfer bzw. ein erfindungsgemäßes Lichtmodul sind wichtige Teile beschrieben, wobei klar ist, dass ein Scheinwerfer noch viele andere, nicht erwähnte Teile enthält, die einen sinnvollen Einsatz in einem Kraftfahrzeug, wie insbesondere einem PKW oder Motorrad, ermöglichen. Der Übersichtlichkeit halber wird beispielsweise auf eine Ansteuerungselektronik, weitere optische Elemente wie eine Primär- oder eine Projektionsoptik, mechanische Verstelleinrichtungen beziehungsweise Halterungen und weitere Teile eines Scheinwerfer-Gehäuses nicht näher eingegangen.

Die Erfindung und weitere Vorteile werden im Folgenden anhand von nicht einschränkenden Ausführungsbeispielen näher beschrieben, die in den beiliegenden Zeichnungen veranschaulicht sind. Die Zeichnungen zeigen in
- Fig. 1: ein Ausführungsbeispiel eines erfindungsgemäßen Lichtmoduls für ein Lichtmodul, insbesondere für einen KFZ-Scheinwerfer, in einer perspektivischen Ansicht,
- Fig. 2: zwei Leiterplatten des Lichtmoduls der Fig. 1 in einer perspektivischen Ansicht von unten,
- Fig. 3: zwei Leiterplatten des Lichtmoduls der Fig. 1, welche über ein Federkontakt-Element miteinander verbunden sind, in einer perspektivischen Ansicht von oben,
- Fig. 4: eine Detailansicht auf das Federkontakt-Element der Fig. 3 in einer perspektivischen Ansicht von oben,
- Fig. 5: das Lichtmodul der Fig. 1 in einer perspektivischen Ansicht von oben,
- Fig. 6: das Lichtmodul der Fig. 1 in einem ersten Zustand in einer perspektivischen Ansicht von unten,
- Fig. 7: das Lichtmodul der Fig. 1 in einem zweiten Zustand in einer perspektivischen Ansicht von unten,
- Fig. 8: das Lichtmodul der Fig. 1 in einem dritten Zustand in einer perspektivischen Ansicht von unten,
- Fig. 9: einen erfindungsgemäßen Fahrzeugscheinwerfer, insbesondere KFZ-Scheinwerfer, mit zwei Lichtmodulen jeweils gemäß der Fig. 1 in einer schematischen Ansicht.

Unter Bezugnahme auf die Figuren werden nun Ausführungsbeispiele der Erfindung näher erläutert. Insbesondere sind für die Erfindung in einem Scheinwerfer bzw. Lichtmodul wichtige Teile dargestellt, wobei klar ist, dass ein Scheinwerfer noch viele andere, nicht gezeigte Teile enthält, die einen sinnvollen Einsatz in einem Kraftfahrzeug, wie insbesondere einem PKW oder Motorrad, ermöglichen. Der Übersichtlichkeit halber sind daher beispielsweise Kühlvorrichtungen für Bauteile, Ansteuerungselektronik, weitere optische Elemente wie eine Primär- oder eine Projektionsoptik, mechanische Verstelleinrichtungen beziehungsweise Halterungen und weitere Teile eines Scheinwerfer-Gehäuses nicht gezeigt.

Die Figuren zeigen ein Ausführungsbeispiel eines erfindungsgemäßen Lichtmoduls 1 in verschiedenen Ansichten und in verschiedenen Schritten des Zusammenbaus der Einzelteile.

Das Lichtmodul 1 umfasst eine erste Leiterplatte 10 und eine zweite Leiterplatte 20, wobei auf der zweiten Leiterplatte 20 mehrere Lichtquellen 21-23 angeordnet sind.

Die erste Leiterplatte 10 und die zweite Leiterplatte 20 sind unter einem Winkel 8, welcher durch die jeweiligen Leiterebenen der ersten und zweiten Leiterplatte 10, 20 eingeschlossen ist, zueinander angeordnet und über zumindest ein Federkontakt-Element 30-35 elektrisch leitend miteinander verbunden.

Zwischen den Oberflächen der ersten Leiterplatte 10 und der zweiten Leiterplatte 20, auf welchen jeweils Leiterbahnen angeordnet werden können, liegt in diesem Beispiel ein rechter Winkel 8 vor. Montagebedingt oder durch eine optische Auslegung eines Scheinwerfers gewünscht, kann der Winkel 8 auch andere Werte annehmen, wie beispielsweise zwischen 45° und 135°, oder zwischen 80° und 100°, oder auch zwischen 85° und 95°.

Die Federkontakt-Elemente 30-35 weisen jeweils einen in einem Halter 50 federnd gelagerten Stift 40 auf. In dieser Ausführungsvariante weist der Stift 40 eine zylindrische Form auf und die Stirnfläche des Stifts 40 ist glatt ausgeführt.

Je nach Ausführungsform, welche beispielsweise einen flacheren Winkel zwischen der ersten und der zweiten Leiterplatte vorsehen kann, kann eine spezielle Formgebung des Stifts des Federkontakt-Elements günstig sein, wie beispielsweise ein flaches, teller- oder zylinderförmiges Ende des Stifts, ein spitzes, pfeilartiges Ende oder ein rundes, kugelförmiges Ende mit einer glatten oder einer aufgerauten Oberfläche. Es ist als Federkontakt-Element auch eine federnd gelagerte Kugel möglich. In diesem Zusammenhang kann es zusätzlich vorteilhaft sein, wenn auf den Kontaktflächen zusätzlich ein elastisches oder fluides Kontaktmittel aufgebracht ist, welches elektrisch leitfähig ist und eingerichtet ist, bei Kontaktieren eines Federkontakt-Elements mit einer Kontaktfläche den Querschnitt der gebildeten elektrischen Verbindung zu vergrößern, um höhere Ströme über die elektrische Verbindung leiten zu können.

Ein Federkontaktelement kann auch einfach aufgebaut sein und keinen Halter für einen Stift aufweisen. Beispielsweise kann das Federkontaktelement auch ein Draht sein, der aus Federstahl gefertigt ist, zur Erhöhung der elektrischen Leitfähigkeit vergoldet ist, und selbst federt. Es ist dabei vorteilhaft, wenn das Federkontaktelement SMT-lötbar ist, um für eine automatische Bestückung der Platine geeignet zu sein.

In dieser Ausführungsform weist die erste Leiterplatte 10 mehrere Kontaktflächen 11-16 auf, welche zur Auflage der Stifte 40 der Federkontakt-Elemente 30-35 vorgesehen sind. Auf der zweiten Leiterplatte 20 ist der Halter 50 der Federkontakt-Elemente 30-35 angeordnet.

Die Kontaktflächen 11-16 sind auf einer außenliegenden Leiterebene der ersten Leiterplatte 10 ausgebildet, beispielsweise jeweils durch eine, durch Strukturierung eines Leiterplattenmaterials hergestellte Metallfläche auf der ersten Leiterplatte 10.

Alternativ dazu kann auf der ersten Leiterplatte der Halter der Federkontakt-Elemente angeordnet sein, und die zweite Leiterplatte jeweils eine Kontaktfläche aufweisen, welche zur Auflage des jeweiligen Stifts der Federkontakt-Elemente vorgesehen ist. In diesem Fall können die Kontaktflächen auf einer Stirnseite der zweiten Leiterplatte ausgebildet sein, beispielsweise jeweils durch eine, durch Galvanisierung aufgebrachte Metallbeschichtung auf der zweiten Leiterplatte. Diese Variante ist in den Figuren nicht gezeigt.

Die erste Leiterplatte 10 umfasst eine Treiberschaltung zur Ansteuerung der Lichtquellen 21-23, wobei dies in den Figuren zur besseren Übersichtlichkeit nicht eingezeichnet ist. Die Treiberschaltung ist mit den Kontaktflächen 11-16 verbunden.

Die erste Leiterplatte 10 ist beispielsweise aus FR4-Material hergestellt.

Die zweite Leiterplatte 20 ist zur besseren Wärmeableitung der Lichtquellen 21-23 aus IMS-Material hergestellt.

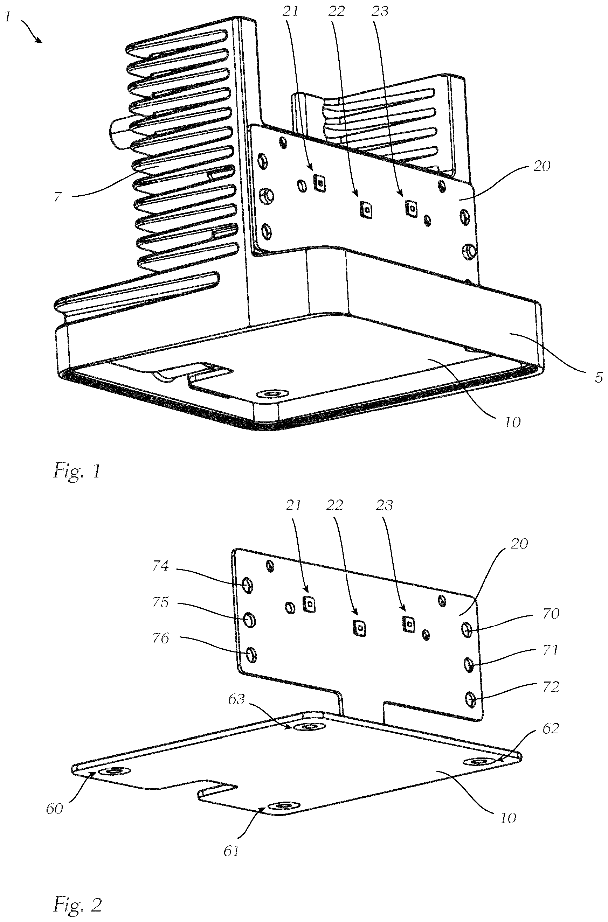

In der Fig. 1 ist das Lichtmodul 1 dargestellt, wobei die erste Leiterplatte 10 und die zweite Leiterplatte 20 in einem Gehäuse 5, welches auch einen Kühlkörper 7 umfasst, eingebaut sind. Der Kühlkörper 7 ist mit der zweiten Leiterplatte 20 verbunden.

Zusätzlich kann vom Kühlkörper 7 auch Wärme aufgenommen werden, welche von der ersten Leiterplatte 10 an das verbundene Gehäuse 5 abgegeben wird und über den Kühlkörper 7 abgegeben wird.

Die Lichtquellen 21-23 sind auf der zweiten Leiterplatte 20 erkennbar.

Fig. 2 zeigt eine Anordnung mit der ersten und zweiten Leiterplatte 10, 20 ohne das Gehäuse.

Die erste Leiterplatte 10 weist Montageöffnungen 60-63 auf.

Die Lichtquellen 21-23 sind auf der zweiten Leiterplatte 20 erkennbar, welche außerdem Montageöffnungen 70-76 aufweist.

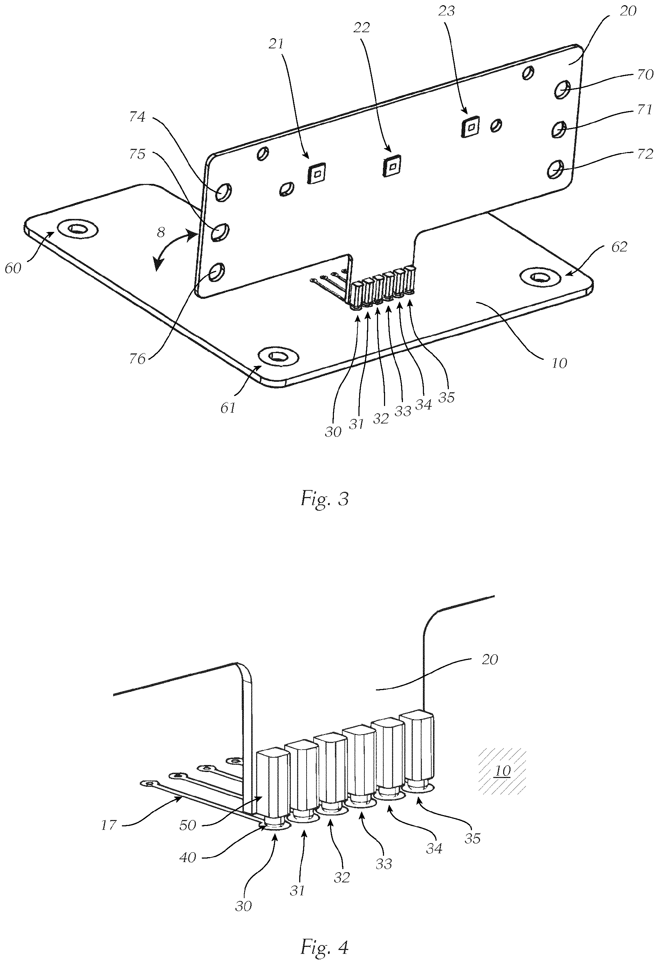

In der Fig. 3 ist wiederum die vorhergehende Anordnung mit zwei Leiterplatten 10, 20 des Lichtmoduls 1, welche über Federkontakt-Elemente 30-35 miteinander verbunden sind gezeigt. Eine Detailansicht in der Fig. 4 zeigt einen vergrößerten Ausschnitt mit den Federkontakt-Elementen 30-35, welche jeweils den Halter 50 sowie den federnd gelagerten Stift 40 umfassen. Der Stift 40 liegt auf einer Kontaktfläche 11 auf.

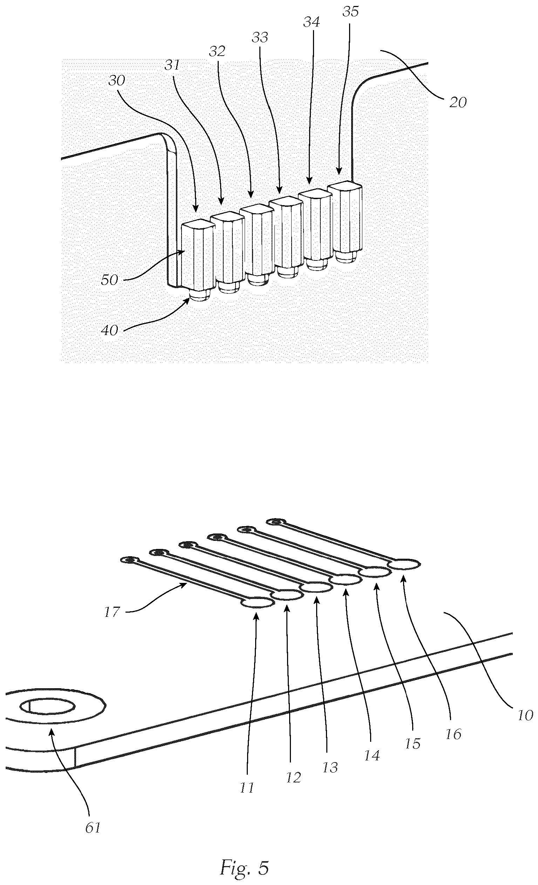

In der nachfolgenden Fig. 5 sind die erste und zweite Leiterplatte 10, 20 des Scheinwerfers 1 veranschaulicht, wobei die Darstellung vereinfacht die erste und zweite Leiterplatte 10, 20 in der endgültigen Orientierung normal zueinander zeigt, jedoch die erste und zweite Leiterplatte 10, 20 nicht miteinander verbunden sind. Dadurch soll die Zuordnung der Federkontakt-Elemente 30-35, bzw. des jeweiligen Stifts 40 zu den Kontaktflächen 11-16 illustriert werden.

Außerdem sind Leiterbahnen 17 eingezeichnet, welche die elektrische Verbindung zu einer Treiberschaltung andeuten sollen. Die Treiberschaltung ist zur vereinfachten Darstellung nicht eingezeichnet, ist aber von der ersten Leiterplatte 10 umfasst.

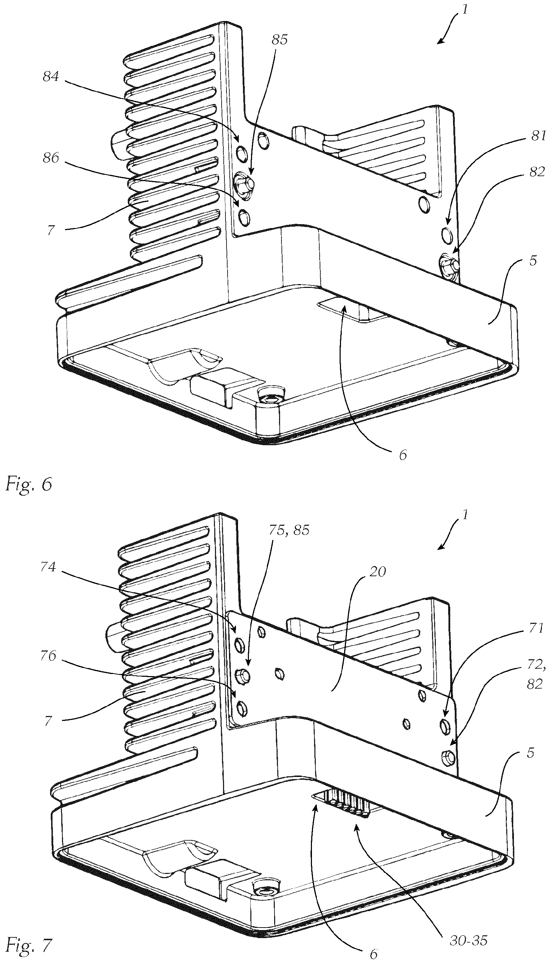

Fig. 6 zeigt das Lichtmodul 1 mit dem Gehäuse 5, welches zwischen dem Bauraum für die erste Leiterplatte 10 und dem Bauraum für die zweite Leiterplatte 20 ein Fenster 6 aufweist. Mit anderen Worten ist zwischen der ersten Leiterplatte 10 und der zweiten Leiterplatte 20 eine elektromagnetische Schirmung mit einem Fenster 6 angeordnet. Die elektromagnetische Schirmung ist somit durch zumindest einen Teil des Gehäuses 5 des Lichtmoduls 1 gebildet.

Zusätzlich weist das Gehäuse 5 Montagevorrichtungen 81-86 auf, wobei die Montagevorrichtungen 82 und 85 jeweils als Zentrierstifte ausgeführt sind.

Fig. 6 zeigt das Lichtmodul 1 in einem ersten Zustand, bei welchem die erste und zweite Leiterplatte 10, 20 noch nicht in das Gehäuse eingesetzt sind.

Fig. 7 zeigt das Lichtmodul 1 in einem zweiten Zustand, bei welchem die zweite Leiterplatte 20 in das Gehäuse 5 eingesetzt ist.

Die Zentrierstifte 82, 85 sind eingerichtet, mit korrespondierenden Öffnungen 72 und 75 auf der zweiten Leiterplatte 20 zusammenzuwirken.

Durch das Fenster 6 ragt zumindest ein Teil der Federkontakt-Elemente 30-35 hindurch.

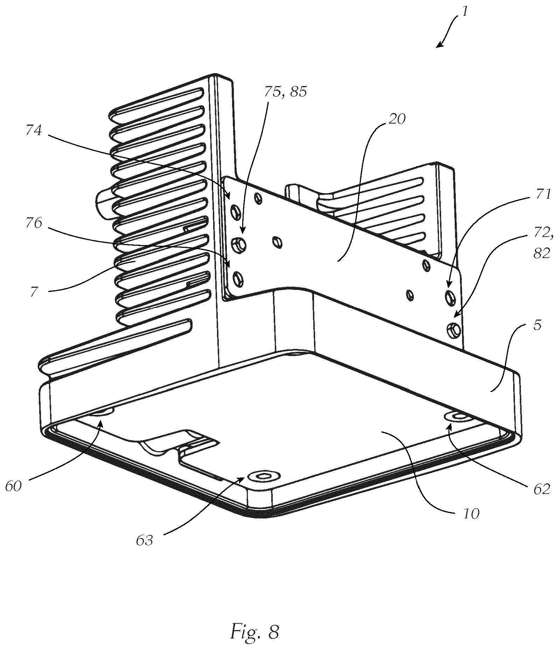

Fig. 8 zeigt das Lichtmodul 1 in einem dritten Zustand, bei welchem auch die erste Leiterplatte 10 in das Gehäuse 5 eingesetzt ist. Die Federkontakt-Elemente 30-35 verbinden die erste und zweite Leiterplatte 10, 20 elektrisch leitend.

Der Einfachheit halber sind die Lichtquellen 21-23 in den Fig. 6-8 nicht eingezeichnet.

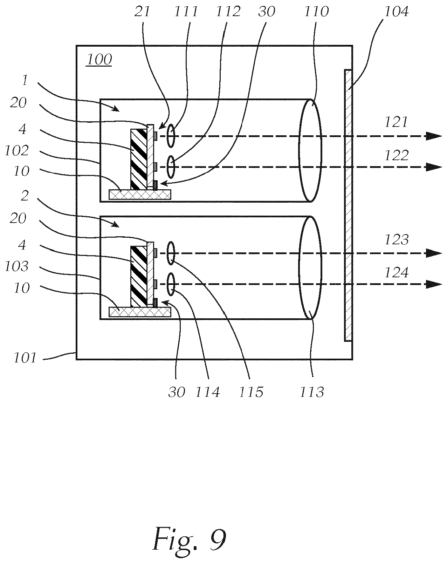

Fig. 9 zeigt schematisch einen erfindungsgemäßen KFZ-Scheinwerfer 100 mit zwei Lichtmodulen 1 und 2. Die Lichtmodule 1 und 2 sind hinsichtlich der Leiterplattenanordnung baugleich ausgeführt, das heißt, sie weisen jeweils erste und zweite Leiterplatten 10 und 20 mit jeweiligen Lichtquellen auf. Je nach Anforderung an den Scheinwerfer 100 können beispielsweise nachgelagerte Optikelemente in Form von optischen Linsen 110-115 unterschiedlich ausgelegt sein und können somit unterschiedliche Lichtverteilungen eines von den Lichtquellen emittierten Lichts formen.

Der Scheinwerfer 100 weist ein Scheinwerfergehäuse 101 auf, in welchem die beiden Lichtmodule 1, 2 in jeweiligen Lichtmodulgehäusen 102,103 untergebracht sind.

Eine optisch transparente Abdeckung 104 ist dazu eingerichtet, von den Lichtquellen emittiertes Licht in Form von Lichtstrahlen 121-124 durchzulassen und abzustrahlen. Der in einem Fahrzeug entsprechend montierte Schweinwerfer 100 ist dazu eingerichtet, eine vor dem Fahrzeug gelegene Fahrbahn auszuleuchten.

### Bezugszeichenliste:

- 1,2: Lichtmodul
- 5: Gehäuse
- 6: Fenster
- 7: Kühlkörper
- 8: Winkel
- 10, 20: Leiterplatte
- 11-16: Kontaktfläche
- 17: Leiterbahn
- 21-23: Lichtquelle
- 30-35: Federkontakt-Element
- 40: Stift eines Federkontakt-Elements
- 50: Halter eines Federkontakt-Elements
- 60-63, 71-76: Montageöffnung
- 81-86: Montagevorrichtungen
- 100: Fahrzeugscheinwerfer
- 101: Scheinwerfergehäuse
- 102, 103: Lichtmodulgehäuse
- 104: transparente Abdeckung
- 110-115: Optikelement, Linse
- 121-124: emittiertes Licht, Lichtstrahl

## Patentansprüche

1. Lichtmodul (1, 2), umfassend ein Gehäuse (5), eine erste Leiterplatte (10) und eine zweite Leiterplatte (20), wobei auf der zweiten Leiterplatte (20) zumindest eine Lichtquelle (21-23) angeordnet ist, wobei die erste Leiterplatte (10) und die zweite Leiterplatte (20) unter einem Winkel (8), welcher durch die jeweiligen Leiterebenen der ersten und zweiten Leiterplatte (10, 20) eingeschlossen ist, zueinander angeordnet sind und über zumindest ein Federkontakt-Element (30-35) elektrisch leitend miteinander verbunden sind, und der Winkel (8) zwischen der ersten Leiterplatte (10) und der zweiten Leiterplatte (20) zwischen 45° und 135° liegt, bevorzugt zwischen 80° und 100° liegt, besonders bevorzugt 90° beträgt, und wobei das Gehäuse (5) zwischen dem Bauraum für die erste Leiterplatte (10) und dem Bauraum für die zweite Leiterplatte (20) ein Fenster (6) aufweist und somit zwischen der ersten Leiterplatte (10) und der zweiten Leiterplatte (20) eine elektromagnetische Schirmung mit einem Fenster (6) bildet, **dadurch gekennzeichnet, dass** das zumindest eine Federkontakt-Element (30-35) einen in einem Halter (50) federnd gelagerten Stift (40) aufweist, und dadurch dass durch das Fenster (6) zumindest ein Teil des zumindest einen Federkontakt-Elements (30-35) hindurch ragt.

2. Lichtmodul (1, 2) nach Anspruch 1, **dadurch gekennzeichnet, dass** die erste Leiterplatte (10) zumindest eine Kontaktfläche (11-16) aufweist, welche zur Auflage des zumindest einen Federkontakt-Elements (30-35) vorgesehen ist, und auf der zweiten Leiterplatte (20) das zumindest eine Federkontakt-Element (30-35) angeordnet ist.

3. Lichtmodul (1, 2) nach Anspruch 1, **dadurch gekennzeichnet, dass** auf der ersten Leiterplatte (10) das zumindest eine Federkontakt-Element (30-35) angeordnet ist, und die zweite Leiterplatte (20) zumindest eine Kontaktfläche (11-16) aufweist, welche zur Auflage des zumindest einen Federkontakt-Elements (30-35) vorgesehen ist.

4. Lichtmodul (1, 2) nach einem der Ansprüche 2 oder 3, **dadurch gekennzeichnet, dass** die zumindest eine Kontaktfläche (11-16) auf einer außenliegenden Leiterebene oder einer Stirnseite der ersten oder zweiten Leiterplatte (10, 20) ausgebildet ist, insbesondere durch eine durch Strukturierung eines Leiterplattenmaterials hergestellte Metallfläche oder eine, beispielsweise durch Galvanisierung aufgebrachte Metallbeschichtung auf der ersten oder zweiten Leiterplatte (10, 20).

5. Lichtmodul (1, 2) nach einem der vorhergehenden Ansprüche, **dadurch gekennzeichnet, dass** auf der zumindest einen Kontaktfläche (11-16) zusätzlich ein elastisches oder fluides Kontaktmittel aufgebracht ist, welches elektrisch leitfähig ist und eingerichtet ist, bei Kontaktieren des zumindest einen Federkontakt-Elements (30-35) mit der zumindest einen Kontaktfläche (11-16) den Querschnitt der gebildeten elektrischen Verbindung zu vergrößern.

6. Lichtmodul (1, 2) nach einem der vorhergehenden Ansprüche, **dadurch gekennzeichnet, dass** die erste Leiterplatte (10) eine Treiberschaltung zur Ansteuerung der zumindest einen Lichtquelle (21-23) umfasst, welche Treiberschaltung mit der zumindest einen Kontaktfläche (11-16) verbunden ist, und die erste Leiterplatte (10) vorzugsweise aus FR4-Material hergestellt ist.

7. Lichtmodul (1, 2) nach einem der vorhergehenden Ansprüche, **dadurch gekennzeichnet, dass** die zweite Leiterplatte (20) aus IMS-Material hergestellt ist.

8. Lichtmodul (1, 2) nach einem der vorhergehenden Ansprüche, umfassend zumindest einen Kühlkörper (7), **dadurch gekennzeichnet, dass** der zumindest eine Kühlkörper (7) mit der zweiten Leiterplatte (20) verbunden ist, und vorzugsweise die erste Leiterplatte (10) auch mit dem zumindest einen Kühlkörper (7) verbunden ist.

9. Fahrzeugscheinwerfer (100), **umfassend** zumindest ein Lichtmodul (1, 2) nach einem der vorhergehenden Ansprüche.

## Claims

1. Light module (1, 2), comprising a housing (5), a first printed circuit board (10) and a second printed circuit board (20), at least one light source (21-23) being arranged on the second printed circuit board (20), wherein the first printed circuit board (10) and the second printed circuit board (20) being arranged at an angle (8), which is enclosed by the respective conductor planes of the first and second printed circuit board (10, 20), are arranged with respect to one another and are electrically conductively connected to one another via at least one spring contact element (30-35), and the angle (8) between the first printed circuit board (10) and the second printed circuit board (20) is between 45° and 135°, preferably between 80° and 100°, particularly preferably 90°, and wherein the housing (5) has a window (6) between the installation space for the first printed circuit board (10) and the installation space for the second printed circuit board (20) and thus forms an electromagnetic shield with a window (6) between the first printed circuit board (10) and the second printed circuit board (20), **characterized in that** the at least one spring contact element (30-35) comprises a pin (40) spring-mounted in a holder (50), and **in that** at least a part of the at least one spring contact element (30-35) projects through the window (6).

2. Light module (1, 2) according to claim 1, **characterized in that** the first printed circuit board (10) has at least one contact surface (11-16) which is provided for supporting the at least one spring contact element (30-35), and the at least one spring contact element (30-35) is arranged on the second printed circuit board (20).

3. Light module (1, 2) according to claim 1, **characterized in that** the at least one spring contact element (30-35) is arranged on the first printed circuit board (10), and the second printed circuit board (20) has at least one contact surface (11-16) which is provided for supporting the at least one spring contact element (30-35).

4. Light module (1, 2) according to one of claims 2 or 3, **characterized in that** the at least one contact surface (11-16) is formed on an outer conductor plane or an end face of the first or second printed circuit board (10, 20), in particular by a metal surface produced by structuring a printed circuit board material or a metal coating applied, for example by electroplating, to the first or second printed circuit board (10, 20).

5. Light module (1, 2) according to one of the preceding claims, **characterized in that** an elastic or fluid contact means is additionally applied to the at least one contact surface (11-16), which means is electrically conductive and is set up to increase the cross section of the electrical connection formed when the at least one spring contact element (30-35) makes contact with the at least one contact surface (11-16).

6. Light module (1, 2) according to one of the preceding claims, **characterized in that** the first printed circuit board (10) comprises a driver circuit for driving the at least one light source (21-23), which driver circuit is connected to the at least one contact area (11-16), and the first printed circuit board (10) is preferably made of FR4 material.

7. Light module (1, 2) according to one of the preceding claims, **characterized in that** the second printed circuit board (20) is made of IMS material.

8. Light module (1, 2) according to any one of the preceding claims, comprising at least one heat sink (7), **characterized in that** the at least one heat sink (7) is connected to the second printed circuit board (20), and preferably the first printed circuit board (10) is also connected to the at least one heat sink (7).

9. Vehicle headlamp (100) comprising at least one light module (1, 2) according to any one of the preceding claims.

## Revendications

1. Module d'éclairage (1, 2), comprenant un boîtier (5), une première carte de circuit imprimé (10) et une seconde carte de circuit imprimé (20), au moins une source de lumière (21-23) étant disposée sur la seconde carte de circuit imprimé (20), la première carte de circuit imprimé (10) et la seconde carte de circuit imprimé (20) étant disposées selon un angle (8), qui est entouré par les plans conducteurs respectifs de la première et de la deuxième carte de circuit imprimé (10, 20), et sont reliés entre eux de manière électriquement conductrice par l'intermédiaire d'au moins un élément de contact à ressort (30-35), et l'angle (8) entre la première carte de circuit imprimé (10) et la deuxième carte de circuit imprimé (20) est compris entre 45° et 135°, de préférence entre 80° et 100°, de manière particulièrement préférée 90°, et dans lequel le boîtier (5) présente une fenêtre (6) entre l'espace d'installation pour la première carte de circuit imprimé (10) et l'espace d'installation pour la seconde carte de circuit imprimé (20) et forme ainsi un écran électromagnétique avec une fenêtre (6) entre la première carte de circuit imprimé (10) et la seconde carte de circuit imprimé (20), **caractérisé en ce que** le au moins un élément de contact à ressort (30-35) comprend une broche (40) montée de manière élastique dans un support (50), et **en ce qu'**au moins une partie du au moins un élément de contact à ressort (30-35) fait saillie à travers la fenêtre (6).

2. Module d'éclairage (1, 2) selon la revendication 1, **caractérisé en ce que** la première carte de circuit imprimé (10) présente au moins une surface de contact (11-16) qui est prévue pour supporter le au moins un élément de contact à ressort (30-35), et le au moins un élément de contact à ressort (30-35) est disposé sur la deuxième carte de circuit imprimé (20).

3. Module d'éclairage (1, 2) selon la revendication 1, **caractérisé en ce que** le au moins un élément de contact à ressort (30-35) est disposé sur la première carte de circuit imprimé (10), et la deuxième carte de circuit imprimé (20) présente au moins une surface de contact (11-16) qui est prévue pour supporter le au moins un élément de contact à ressort (30-35).

4. Module d'éclairage (1, 2) selon l'une des revendications 2 ou 3, **caractérisé en ce que** l'au moins une surface de contact (11-16) est formée sur un plan conducteur extérieur ou une face frontale de la première ou de la deuxième carte de circuit imprimé (10, 20), notamment par une surface métallique réalisée par structuration d'un matériau de carte de circuit imprimé ou par un revêtement métallique appliqué, par exemple par galvanoplastie, sur la première ou la deuxième carte de circuit imprimé (10, 20).

5. Module d'éclairage (1, 2) selon l'une des revendications précédentes, **caractérisé en ce qu'**un moyen de contact élastique ou fluide est en outre appliqué sur la au moins une surface de contact (11-16), lequel moyen de contact est électriquement conducteur et est configuré pour augmenter la section transversale de la connexion électrique formée lorsque le au moins un élément de contact à ressort (30-35) entre en contact avec la au moins une surface de contact (11-16).

6. Module d'éclairage (1, 2) selon l'une des revendications précédentes, **caractérisé en ce que** la première carte de circuit imprimé (10) comprend un circuit de commande pour commander la au moins une source de lumière (21-23), lequel circuit de commande est connecté à la au moins une surface de contact (11-16), et la première carte de circuit imprimé (10) est de préférence réalisée en matériau FR4.

7. Module d'éclairage (1, 2) selon l'une quelconque des revendications précédentes, **caractérisé en ce que** la deuxième carte de circuit imprimé (20) est réalisée en matériau IMS.

8. Module d'éclairage (1, 2) selon l'une quelconque des revendications précédentes, comprenant au moins un dissipateur thermique (7), **caractérisé en ce que** le au moins un dissipateur thermique (7) est connecté à la deuxième carte de circuit imprimé (20), et de préférence la première carte de circuit imprimé (10) est également connectée au au moins un dissipateur thermique (7).

9. Projecteur (100) de véhicule comprenant au moins un module d'éclairage (1, 2) selon l'une quelconque des revendications précédentes.
